# EUROPÄISCHE PATENTSCHRIFT

(11) **EP 1 528 606 B1**
(45) Veröffentlichungstag und Bekanntmachung des Hinweises auf die Patenterteilung: **06.06.2007**
(21) Anmeldenummer: 04105078.2
(22) Anmeldetag: 15.10.2004
(51) Int. Cl.: H01L 41/053

(54) **Aktormodul**
Actuator module
Module actionneur

(30) Priorität: 27.10.2003 DE 10350061
(43) Veröffentlichungstag der Anmeldung: 04.05.2005
(73) Patentinhaber: ROBERT BOSCH GMBH, 70442 Stuttgart (DE)
(72) Erfinder: Stier, Hubert, 71665, Vaihingen/Enz (DE)
(74) Vertreter: Körfer, Thomas

(56) Entgegenhaltungen:
- WO-A-01/91197
- DE-A1- 19 650 900
- DE-A1- 19 914 411
- DE-C1- 19 715 488
- US-A- 5 148 077

## Beschreibung

### Stand der Technik

Die Erfindung geht aus von einem piezoelektrischen oder magnetostriktiven Aktormodul nach der Gattung des Hauptanspruchs.

Beispielsweise ist aus der DE 198 56 186 A1 ein piezoelektrischer Aktor bekannt, welcher insbesondere zur Betätigung von Steuerventilen oder Einspritzventilen an Verbrennungsmotoren in Kraftfahrzeugen dient, wobei der Aktor einen piezoelektrischen Aktorkörper, insbesondere in Form eines vielschichtigen Laminats aus aufeinandergeschichteten Lagen piezoelektrischen Materials und dazwischenliegenden metallischen bzw. elektrisch leitenden Schichten, aufweist. Eine der Stirnseiten des Aktorkörpers ist an einem Aktorfuß festgelegt. Der Aktorkörper ist unter Einhaltung eines Zwischenraums von einer Modulwand umgeben, wobei der Zwischenraum mit einem elastischen oder plastischen, elektrisch isolierenden Stoff guter Wärmeleitfähigkeit ausgefüllt ist.

Nachteilig an dem aus der DE 198 56 186 A1 bekannten Aktor sind insbesondere die hohen Fertigungskosten und der hohe Fertigungsaufwand. Diese sind dadurch bedingt, daß der Aktor mittels eines Federbandes vorgespannt wird und die Aktorumspritzung deshalb mit einem relativ dünnflüssigen Material erfolgen muß, um das Aktormodul zum einen allseits ohne Hohlräume umgeben zu können und zum anderen die Elastizität zu erhalten. Die Anforderungen an das Umspritzungsmaterial sind daher sehr hoch, wodurch das Material teuer wird.

Weiterhin ist von Nachteil, daß eine Zentrierung des Aktors praktisch nicht möglich ist und der Aktorkörper dementsprechend von einem geräumigen Zwischenraum umgeben sein muß, was wiederum die Größe des Gesamtbauteils negativ beeinflußt.

Zudem kann der Aktor aufgrund seine Empfindlichkeit gegenüber Scherkräften während der Umspritzung beschädigt werden, wodurch sich die Herstellungskosten weiter erhöhen.

Aus der DE 199 14 411 A1 ist ein piezoelektrischer Aktor bekannt, bei dem ein Aktorkörper in eine Axialbohrung eines Ventilgehäuses eingesetzt wird. Hierbei ist der Außendurchmesser des Aktorkörpers etwas größer als der Innendurchmesser des Axialbohrung.

In der WO 01/91197 A1 wird ein Aktor vorgestellt, bei dem sich das Aktormodul innerhalb einer Hülse mit Ausnehmungen, zum Beispiel Löcher oder Schlitze, befindet. Diese Hülse ist von einem wärmeleitfähigen Elastomer umgeben.

### Vorteile der Erfindung

Das erfindungsgemäß ausgestaltete Aktormodul mit den Merkmalen des Hauptanspruchs hat demgegenüber den Vorteil, daß eine auf das Aktormodul aufgeklipste geschlitzte metallische Hülse, welche eine hohe Wärmeleitfähigkeit aufweist, die thermische Anbindung des Aktormoduls an ein Aktorgehäuse gewährleistet. Ein solches Aktormodul ist einfach und kostengünstig mit geringem Aufwand herstellbar.

Durch die in den Unteransprüchen aufgeführten Maßnahmen sind vorteilhafte Weiterbildungen und Verbesserungen des im Hauptanspruch angegebenen Aktors möglich.

Vorteilhafterweise besteht die Hülse aus Metall, insbesondere aus den hoch wärmeleitfähigen Metallen Kupfer oder Aluminium.

Zudem ist vorteilhaft, daß die Hülse geschlitzt und in einfacher Weise durch Stanzen und Biegen in einer beliebigen Wandstärke von ca. 0,2 bis 0,6 mm herstellbar ist.

### Zeichnung

Ein Ausführungsbeispiel der Erfindung ist in der Zeichnung vereinfacht dargestellt und in der nachfolgenden Beschreibung näher erläutert. Es zeigen:
- Fig. 1A: eine schematische geschnittene Ansicht eines erfindungsgemäß ausgestalteten piezoelektrischen Aktormoduls,
- Fig. 1B: eine auszugsweise schematische Ansicht der Hülse des in Fig. 1A dargestellten erfindungsgemäß ausgebildeten Aktormoduls in einer geschnittenen Ansicht,
- Fig. 1C: einen Schnitt senkrecht zur Längsachse der in Fig. 1B dargestellten Hülse und
- Fig. 2A-B: eine schematische Darstellung des Temperaturverlaufs über die Länge des Aktormoduls ohne und mit der erfindungsgemäßen Hülse.

### Beschreibung des Ausführungsbeispiels

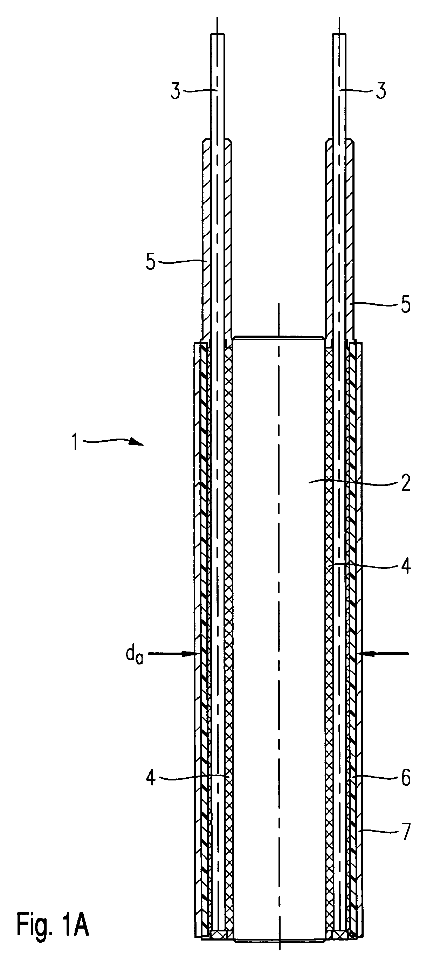

Ein in Fig. 1A dargestelltes Aktormodul 1 dient z. B. zur Betätigung eines Brennstoffeinspritzventils, welches insbesondere zur direkten Einspritzung von Brennstoff in den Brennraum einer gemischverdichtenden, selbst- oder fremdgezündeten Brennkraftmaschine geeignet ist.

Das Aktormodul 1 besteht aus einem piezoelektrischen oder magnetostriktiven Element 2. Dieses kann sowohl monolithisch ausgeführt sein als auch aus scheibenförmigen piezoelektrischen oder magnetostriktiven Schichten bestehen, welche untereinander verklebt sein können.

Das Aktormodul 1 ist mit Kontaktstiften 3 zur Kontaktierung versehen. Die Kontaktstifte 3 und das piezoelektrische oder magnetostriktive Element 2 sind von einer Umspritzung 4 umgeben, in welche die Kontaktstifte 3 eingebettet sind. Außerhalb der Umspritzung 4 sind die Kontaktstifte 3 von Isolierhülsen 5 umgeben. Die Umspritzung 4 wird dabei durch eine Kunststoffhülse 6 geformt, welche über das piezoelektrische oder magnetostriktive Element 2 geschoben und dann mit der Spritzgußmasse für die Umspritzung 4 gefüllt wird. Die Umspritzung 4 dient der Wärmeableitung der durch das piezoelektrische oder magnetostriktive Element 2 erzeugten Verlustwärme während des Betriebs.

Nach dem Anbringen der Umspritzung 4 ist das Aktormodul 1 für weitere Montageschritte wie das Vorspannen und das Einsetzen in eine nicht weiter dargestellte Rohrfeder bereit. Da die Umspritzung 4 und die Rohrfeder aus fertigungstechnischen Gründen nicht in direktem Kontakt mit der Rohrfeder stehen, müssen entsprechende Maßnahmen ergriffen werden, um das Aktormodul 1 thermisch an die Rohrfeder bzw. ein diese umschließendes Aktorgehäuse zu koppeln.

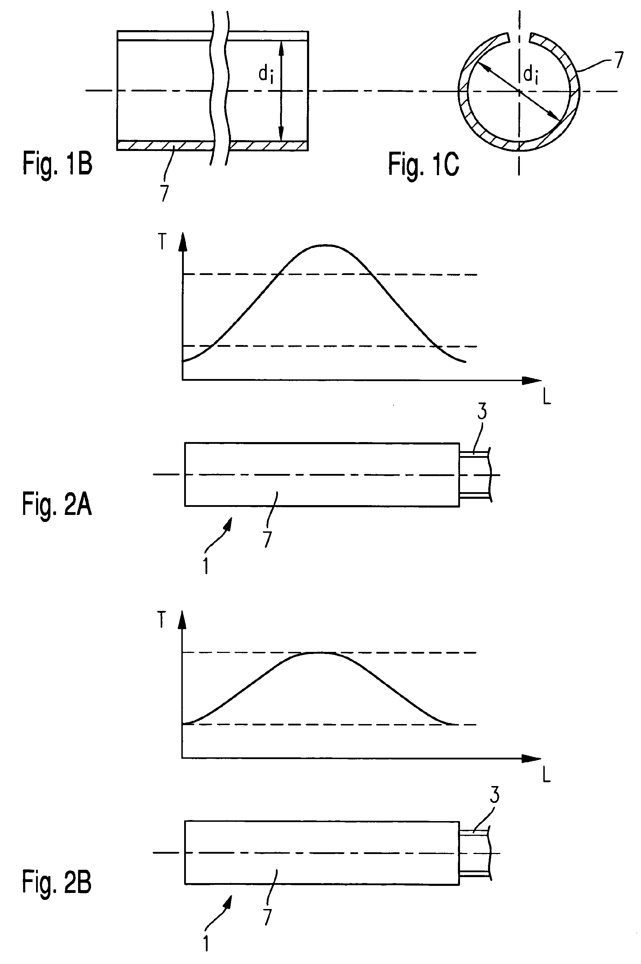

Zu diesem Zweck ist erfindungsgemäß eine Hülse 7 vorgesehen, welche die Kunststoffhülse 6 umschließt. Wie aus Fig. 1B und 1C ersichtlich, ist die Hülse 7 dabei in Form einer geschlitzten Hülse 7 ausgebildet, deren Innendurchmesser dᵢ geringfügig kleiner ist als ein Außendurchmesser dₐ des Aktormoduls 1. Dadurch kann erreicht werden, daß die auf das Aktormodul 1 aufgeklipste Hülse 7 im montierten Zustand überall gut an der Kunststoffhülse 6 anliegt und ein optimaler Wärmeübergang vom Aktormodul in die Hülse 7 stattfinden kann.

Die Hülse 7 ist vorzugsweise aus Metall durch Stanzen und anschließendes Biegen hergestellt, was eine einfache, schnelle und kostengünstige Herstellung ermöglicht. Als Material wird vorzugsweise Aluminium, Kupfer, eine Legierung hieraus oder ein anderes Metall oder eine andere Legierung, z. B. Messing, mit hoher Wärmeleitfähigkeit verwendet. Die Wandstärke der Hülse 7 beträgt dabei etwa 0,2 bis 0,6 mm.

Fig. 2A und 2B zeigen zwei schematische Diagramme der Verteilung der Temperatur T in einem Aktormodul 1 ohne Hülse 7 und mit Hülse 7 jeweils als Funktion des Orts L.

Ohne die Hülse 7 ergibt sich eine Temperaturverteilung gemäß Fig. 2A. Da die axiale Wärmeleitfähigkeit des piezoelektrischen oder magnetostriktiven Elements 2 relativ gering ist, wird das Aktormodul 1 in der Mitte seiner axialen Erstreckung sehr warm. An den Enden ist die Temperatur deutlich geringer, da Wärme über die Stirnflächen abgeleitet wird.

Mit der Hülse 7 ergibt sich eine Temperaturverteilung gemäß Fig. 2B. Das Temperturmaximum in der axialen Mitte des Aktormoduls ist geringer, die Temperatur in den Endbereichen deutlich höher als in Fig. 2A, da die metallische Hülse 7 die Wärme von der Mitte in die Endbereiche abführen kann.

Da die Verlustleistung des piezoelektrischen oder magnetostriktiven Elements 2 ungefähr proportional zur Drehzahl der Brennkraftmaschine ist und die Verlustleistung proportional zur maximalen Temperatur in dem piezoelektrischen oder magnetostriktiven Element 2 ist, ermöglicht die Verwendung der Hülse 7 somit höhere Drehzahlen der Brennkraftmaschine.

Die Erfindung ist nicht auf das dargestellte Ausführungsbeispiel beschränkt und insbesondere bei einer Vielzahl von Bauweisen von Brennstoffeinspritzventilen anwendbar. Auch sind alle Merkmale des Ausführungsbeispiels beliebig miteinander kombinierbar.

## Patentansprüche

1. Aktormodul (1), insbesondere zur Betätigung von Brennstoffeinspritzventilen (1) für Brennstoffeinspritzanlagen von Brennkraftmaschinen, mit zumindest einem piezoelektrischen oder magnetostriktiven Element (2) und Kontaktstiften (3) zur elektrischen Kontaktierung des piezoelektrischen oder magnetostriktiven Elements (2),
wobei das Aktormodul (1) eine Umspritzung (4) aufweist, und wobei das Aktormodul (1) von einer Hülse (7) umschlossen ist, deren Innendurchmesser (dᵢ) geringfügig kleiner als ein Außendurchmesser (dₐ) des Aktormoduls (1) ohne Hülse (7) ist,
**dadurch gekennzeichnet,**
**daß** die Hülse (7) axial geschlitzt ausgebildet ist.

2. Aktormodul nach Anspruch 1,
**dadurch gekennzeichnet,**
**daß** die Hülse (7) vollflächig an einer Kunststoffhülse (6) des Aktormoduls (1) anliegt.

3. Aktormodul nach einem der Ansprüche 1 bis 2,
**dadurch gekennzeichnet,**
**daß** die Hülse (7) aus Metall besteht.

4. Aktormodul nach Anspruch 3,
**dadurch gekennzeichnet,**
**daß** die Hülse aus Kupfer oder Aluminium oder einer Legierung hieraus besteht.

5. Aktormodul nach einem der Ansprüche 1 bis 4,
**dadurch gekennzeichnet,**
**daß** die Hülse (7) eine Wandstärke von 0,2 bis 0,6 mm aufweist.

6. Aktormodul nach einem der Ansprüche 1 bis 5,
**dadurch gekennzeichnet,**
**daß** die Hülse (7) mittels Stanzen und Biegen hergestellt ist.

7. Aktormodul nach einem der Ansprüche 1 bis 6,
**dadurch gekennzeichnet,**
**daß** die Hülse (7) die thermische Koppelung des Aktormoduls (1) an weitere Bauteile ermöglicht.

## Claims

1. Actuator module (1), in particular for operation of fuel injection valves (1) for fuel injection systems for internal combustion engines, having at least one piezoelectric or magnetostrictive element (2) and contact pins (3) for making electrical contact with the piezoelectric or magnetostrictive element (2),
with the actuator module (1) having an extruded coating (4) and with the actuator module (1) being surrounded by a sleeve (7) whose internal diameter (dᵢ) is slightly smaller than the external diameter (dₐ) of the actuator module (1) without the sleeve (7),
**characterized in that**
the sleeve (7) is axially slotted.

2. Actuator module according to Claim 1, **characterized in that** the sleeve (7) rests over its complete area on a plastic sleeve (6) of the actuator module (1).

3. Actuator module according to one of Claims 1 or 2, **characterized in that** the sleeve (7) is composed of metal.

4. Actuator module according to Claim 3, **characterized in that** the sleeve is composed of copper or aluminium, or of an alloy of them.

5. Actuator module according to one of Claims 1 to 4, **characterized in that** the sleeve (7) has a wall thickness of 0.2 to 0.6 mm.

6. Actuator module according to one of Claims 1 to 5, **characterized in that** the sleeve (7) is produced by means of stamping and bending.

7. Actuator module according to one of Claims 1 to 6, **characterized in that** the sleeve (7) allows thermal coupling of the actuator module (1) to further components.

## Revendications

1. Module d'actionneur (1), en particulier pour l'actionnement d'injecteurs de carburant (1) de moteurs à combustion interne, comprenant au moins un élément piézoélectrique ou magnétostrictif (2) ainsi que des tiges de contact (3) pour la mise en contact électrique de l'élément piézoélectrique ou magnétostrictif (2), le module d'actionneur (1) présentant un surmoulage par injection (4), et le module d'actionneur (1) étant entouré par une douille (7) dont le diamètre intérieur (dᵢ) est légèrement inférieur à un diamètre extérieur (dₐ) du module d'actionneur (1) sans douille (7),
**caractérisé en ce que**
la douille (7) est fendue axialement.

2. Module d'actionneur selon la revendication 1,
**caractérisé en ce que**
la douille (7) repose avec toute sa surface contre une douille en matière synthétique (6) du module d'actionneur (1).

3. Module d'actionneur selon l'une des revendications 1 et 2,
**caractérisé en ce que**
la douille (7) est en métal.

4. Module d'actionneur selon la revendication 3,
**caractérisé en ce que**
la douille est en cuivre, en aluminium, ou en un alliage de ces derniers.

5. Module d'actionneur selon l'une des revendications 1 à 4,
**caractérisé en ce que**
la douille (7) présente une épaisseur de paroi de 0,2 à 0,6 mm.

6. Module d'actionneur selon l'une des revendications 1 à 5,
**caractérisé en ce que**
la douille (7) est fabriquée par emboutissage et cintrage.

7. Module d'actionneur selon l'une des revendications 1 à 6,
**caractérisé en ce que**
la douille (7) permet le couplage thermique du module d'actionneur (1) avec d'autres composants.
